(19) Europäisches Patentamt / European Patent Office / Office européen des brevets

(11) **EP 3 029 680 A1**

(12) **DEMANDE DE BREVET EUROPEEN**

(43) Date de publication:
**08.06.2016 Bulletin 2016/23**

(51) Int Cl.:
**G11C 7/20** (2006.01)    **G11C 13/00** (2006.01)
**G11C 29/02** (2006.01)

(21) Numéro de dépôt: **15196806.2**

(22) Date de dépôt: **27.11.2015**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **02.12.2014 FR 1461761**

(71) Demandeurs:
• **COMMISSARIAT A L'ENERGIE ATOMIQUE ET AUX ENERGIES ALTERNATIVES**
  **75015 Paris (FR)**

• **Université Joseph Fourier - Grenoble**
  **38041 Grenoble Cedex 9 (FR)**

(72) Inventeurs:
• **VIANELLO, Elisa**
  **38000 GRENOBLE (FR)**
• **GARBIN, Daniele**
  **10093 COLLEGNO (IT)**

(74) Mandataire: **Cabinet Camus Lebkiri**
  **25, Rue de Maubeuge**
  **75009 Paris (FR)**

(54) **PROCEDE DE PROGRAMMATION D'UNE MEMOIRE VIVE RESISTIVE**

(57) Un aspect de l'invention concerne un procédé de programmation d'une mémoire vive résistive passant d'un état isolant à un état conducteur, ladite mémoire comprenant une première électrode et une seconde électrode séparées par une couche en matériau électriquement isolant, et passant pour la première fois de l'état isolant à l'état conducteur par application d'une tension seuil VFORMING entre les première et seconde électrodes, un premier courant limité ICFORMING circulant dans ladite mémoire après le passage de l'état isolant à l'état conducteur, le premier courant limité ICFORMING étant limité par des moyens de limitation de courant, le procédé de programmation comportant une étape dite « étape de SET » durant laquelle une tension VSET est appliquée entre les première et seconde électrodes pour le passage de la mémoire vive résistive d'un état conducteur hautement résistif vers un état conducteur faiblement résistif, un deuxième courant limité ICSET circulant dans la mémoire vive résistive après le passage de l'état conducteur hautement résistif à l'état conducteur faiblement résistif, le deuxième courant limité ICSET étant limité par lesdits moyens de limitation de courant, le deuxième courant limité ICSET étant choisi strictement inférieur au premier courant limité ICFORMING.

FIG. 4

EP 3 029 680 A1

**Description**

**DOMAINE TECHNIQUE DE L'INVENTION**

La présente invention concerne le domaine des mémoires réinscriptibles non volatiles, et plus spécifiquement celui des mémoires vives résistives de type OxRRAM et CBRAM. Une mémoire vive résistive comprend des première et seconde électrodes séparées par une couche en matériau électriquement isolant, et passe d'un état isolant à un état conducteur par application d'une tension seuil VSET entre les première et seconde électrodes.

**ARRIERE-PLAN TECHNOLOGIQUE DE L'INVENTION**

En fonction des applications et des performances visées, différents types de mémoires sont utilisées.
Ainsi, les mémoires de type SRAM, ou mémoires vives statiques, offrent des temps d'écriture ultra-rapides, requis par exemple lors de calculs par un microprocesseur. L'inconvénient majeur de ces mémoires est qu'elles sont volatiles et que la taille du point mémoire relativement grande ne permet pas d'obtenir une grande capacité de stockage dans un volume raisonnable.
Les mémoires de type DRAM, ou mémoires vives dynamiques, réalisant le stockage de charges électriques dans des capacités, offrent une grande capacité de stockage. Ces mémoires possèdent toutefois des temps d'écriture plus élevés (quelques dizaines de nanosecondes) que ceux des mémoires de type SRAM et sont elles aussi volatiles, le temps de rétention de l'information étant de l'ordre de quelques dizaines de millisecondes.
A l'inverse, pour des applications qui nécessitent un stockage de l'information même lorsque la tension est coupée, on connait également des dispositifs mémoire à l'état solide qui conservent l'information en l'absence d'alimentation :

　　ces dispositifs sont appelés mémoires non volatiles. Ainsi, depuis de nombreuses années, différentes solutions technologiques ont été développées, et ont conduit à la disponibilité de mémoires non volatiles pouvant être écrites et effacées électriquement. On peut citer par exemple :

-　　les EPROMs (« Erasable Programmable Read Only Memories » en anglais, ou mémoires mortes effaçables et programmables), dont le contenu peut être écrit électriquement, mais qui doivent être soumises à un rayonnement UV pour effacer les informations mémorisées ;
-　　les EEPROMs (« Electrically Erasable Programmable ROMs » en anglais, ou mémoires mortes effaçables et programmables électriquement), dont le contenu peut être écrit et effacé électriquement, mais qui requièrent, pour leur réalisation, des surfaces de semi-conducteur plus importantes que les mémoires de type EPROM, et qui sont donc plus coûteuses à réaliser.

Les deux solutions mentionnées ci-dessus présentant des limites dans leur application, les fabricants se sont mis à la recherche d'une mémoire non volatile idéale, qui combinerait les caractéristiques suivantes : écriture et effacement électrique, haute densité et faible coût par bit, accès aléatoire, temps d'écriture et de lecture courts, bonne endurance, mais aussi faible consommation et faible tension d'alimentation.
Il existe également des mémoires non volatiles, appelées mémoires Flash, qui ne présentent pas les inconvénients des mémoires EPROMs ou EEPROMs mentionnés ci-dessus. En effet, une mémoire Flash est formée d'une pluralité de cellules mémoires pouvant être programmées électriquement de manière individuelle, un grand nombre de cellules, appelé bloc, secteur ou page, pouvant être effacées simultanément et électriquement. Les mémoires Flash combinent à la fois l'avantage des mémoires EPROMs en termes de densité d'intégration et l'avantage des mémoires EEPROMs en termes d'effacement électrique.
De plus, la durabilité et la faible consommation électrique des mémoires Flash les rendent intéressantes pour de nombreuses applications : appareils photos numériques, téléphones cellulaires, imprimantes, assistants personnels, ordinateurs portables, ou encore dispositifs portables de lecture et d'enregistrement sonore, clés USB, etc. De plus, les mémoires Flash ne possèdent pas d'éléments mécaniques, ce qui leurs confère une assez grande résistance aux chocs. A l'ère du « tout numérique », ces produits se sont grandement développés, permettant une explosion du marché des mémoires Flash.
La plupart des mémoires Flash non-volatiles du commerce utilisent le stockage de charges comme principe de codage de l'information. En pratique, une couche de piégeage de charge (généralement du polysilicium, ou un diélectrique comme le SiN) est encapsulée entre deux diélectriques dans l'empilement de grille d'un transistor MOS. La présence ou l'absence de charge dans ce médium modifie la conduction du transistor MOS et permet de coder l'état de la mémoire.
Plus récemment, d'autres types de mémoires non volatiles réinscriptibles sont apparus pour réduire les tensions et temps de programmation des mémoires Flash ; on peut notamment citer les mémoires ferroélectriques (mémoires FeRAM ou « Ferroelectric RAM »), basées sur le basculement de la polarisation, ou les mémoires magnétiques (mémoires MRAM ou « Magnetic RAM) qui utilisent la direction du champ magnétique rémanent dans le matériau actif. Cependant, les mémoires FeRAM et MRAM présentent des difficultés qui limitent leur réduction d'échelle.

Afin de surmonter ces difficultés, on connait les mémoires à résistance variable (appelées mémoires RRAM ou « Resistive RAM ») ; ces dernières sont aujourd'hui le sujet d'une grande attention. Les mémoires de type résistive peuvent présenter au moins deux états « off » ou « on » correspondant au passage d'un état résistif (état « HRS ») à un état moins résistif (état « LRS »)).

Les mémoires vives à résistance variable sont aujourd'hui le sujet d'une grande attention, en raison notamment de leur faible consommation électrique et de leur vitesse de fonctionnement élevée.

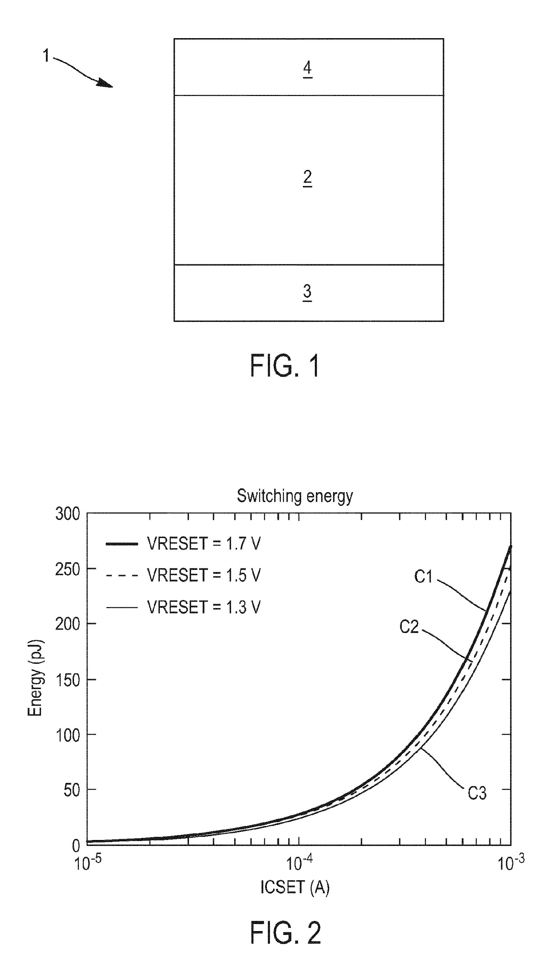

Les données binaires 0 ou 1 sont stockées dans une structure Métal/Isolant/Métal (MIM) présentant deux états de résistance distincts. La figure 1 représente la structure d'une cellule mémoire RRAM 1 de type MIM. Ce dispositif 1 est formé par un empilement comportant une zone active de mémorisation 2 disposée entre une électrode inférieure conductrice 3 et une électrode supérieure conductrice 4.

Ainsi, la cellule mémoire de type résistive peut basculer de manière réversible d'un état fortement résistif « HRS » (« High Résistance State »), appelé également état « OFF », vers un état faiblement résistif « LRS » (« Low Résistance State ») ou état « ON ». Elle peut donc être utilisée pour stocker une information binaire.

Le mécanisme d'écriture est appelé SET dans le cadre des RRAM et consiste à passer de l'état HRS à l'état LRS. Pour effacer l'information, le matériau actif est commuté de l'état LRS vers l'état HRS, le mécanisme d'effacement étant appelé RESET. Les états LRS et HRS sont tous les deux conducteurs (avec bien entendu une meilleure conduction de l'état LRS par rapport à l'état HRS) ; or dans l'état initial, le matériau actif de la zone active de mémorisation 2 est isolant (état PRS, « Pristine Résistance State »). Un premier stress électrique doit donc être appliqué sur la cellule mémoire vierge afin de générer l'état LRS pour la première fois. Le processus associé, appelé FORMING, consiste en un claquage partiellement réversible du matériau actif, c'est-à-dire qu'après le passage de l'état isolant PRS à l'état conducteur LRS, la résistance de l'état conducteur peut être basculée sur l'état HRS avec un stress électrique plus faible (opération de RESET).

Le phénomène de changement de résistance est observé dans différents types de matériaux, ce qui suggère des mécanismes de fonctionnement différents. On peut ainsi distinguer plusieurs types de mémoires résistives. Le domaine de la présente invention concerne plus particulièrement deux catégories de mémoires résistives :

- les mémoires comportant une zone active basée sur un matériau actif à base d'oxyde (mémoire OxRRAM ou « Oxyde RRAM ») tel qu'un oxyde binaire d'un métal de transition ;
- les mémoires comportant une zone active basée sur un matériau à conduction ionique (mémoires CBRAM ou « Conductive Bridging RAM ») formant un électrolyte solide à conduction ionique disposé entre une électrode formant une cathode inerte et une électrode comportant une portion de métal ionisable, c'est-à-dire une portion de métal pouvant facilement former des ions métalliques, et formant une anode.

Le fonctionnement des mémoires CBRAM est basé sur la formation, au sein de l'électrolyte solide, d'un ou plusieurs filaments métalliques (appelés également « dendrites ») entre ses deux électrodes lorsque ces électrodes sont portées à des potentiels appropriés. La formation du filament permet d'obtenir une conduction électrique donnée entre les deux électrodes. En modifiant les potentiels appliqués aux électrodes, il est possible de modifier la répartition du filament, et de modifier ainsi la conduction électrique entre les deux électrodes. Par exemple, en inversant le potentiel entre les électrodes, il est possible de faire disparaître ou de réduire le filament métallique, de manière à supprimer ou à réduire considérablement la conduction électrique due à la présence du filament. A l'état « HRS », les ions métalliques issus de la portion de métal ionisable de l'électrode soluble sont dispersés dans tout l'électrolyte solide. Ainsi, aucun contact électrique n'est établi entre la cathode et l'anode, c'est-à-dire entre l'électrode supérieure et l'électrode inférieure. L'électrolyte solide comporte une zone électriquement isolante de grande résistivité entre l'anode et la cathode. Lorsqu'un potentiel VSET positif est appliqué sur l'anode, une réaction d'oxydoréduction a lieu à cette électrode, créant des ions mobiles. Les ions se déplacent alors dans l'électrolyte sous l'effet du champ électrique appliqué aux électrodes. Arrivés à l'électrode inerte (la cathode), les ions sont réduits, entraînant la croissance d'un filament métallique. Le filament croît préférentiellement dans la direction de l'électrode soluble. La mémoire passe alors dans l'état « LRS » lorsque le filament permet le contact entre les électrodes, rendant l'empilement conducteur. Cette phase constitue le « SET » de la mémoire.

Pour passer à l'état « HRS » (phase de « RESET » de la mémoire), une tension VRESET négative est appliquée sur l'anode, entraînant la dissolution du filament conducteur.

S'agissant des mémoires OxRRAM, comme pour les mémoires CBRAM, le modèle filamentaire bénéficie d'un large consensus. Il repose donc également sur la formation et la rupture d'un ou plusieurs chemins de conduction (filaments conducteurs) dans la matrice d'oxyde, connectant les deux électrodes. La formation et la rupture des filaments conducteurs sont attribuées à la présence de lacunes d'oxygène.

Il est important de noter que, dans le cas des OxRRAM comme dans le cas des CBRAM, l'opération de SET permet de faire passer la cellule mémoire d'un état haute résistance HRS à un état basse résistance LRS. Comme évoqué plus haut, le SET est réalisé en appliquant une tension suffisante VSET aux bornes de l'élément mémoire. La transition entre l'état haute et basse résistance (proche d'un claquage d'oxyde dans le cas d'une mémoire OxRRAM) est très rapide et se traduit par une augmentation brutale du courant lorsque la tension VSET est atteinte. Cette augmentation brutale du courant n'est pas autolimitée. Si rien n'est fait pour contrôler cette augmentation le courant va augmenter jusqu'à des valeurs très élevées susceptibles d'entrainer une augmentation très importante de la température et une destruction du dispositif mémoire. Il est donc nécessaire de limiter l'augmentation du courant à une certaine valeur afin d'obtenir un état basse résistance tout en gardant un dispositif mémoire intègre. Ce courant limité ICSET est appelé indifféremment limitation de courant ou courant d'ajustement (« compliance » en anglais).

La limitation de courant nécessaire pendant l'opération d'écriture peut être réalisée par différents moyens tels qu'une résistance ou un transistor en série avec la mémoire : l'ajout d'une résistance ou d'un transistor en série permet de limiter le courant passant dans l'ensemble point mémoire et résistance/transistor série. L'avantage d'utiliser un transistor par rapport à une résistance série est de pouvoir contrôler le niveau de limitation à l'aide de la tension de grille. Plus la tension de grille est importante, plus le courant de saturation sera important. Le transistor fait ainsi office de moyen de réglage de la limitation de courant dans l'élément mémoire.

Une voie de développement concerne l'endurance des mémoires OxRRAM et CBRAM, c'est-à-dire le nombre de cycles écriture/effacement, autrement dit le nombre de cycles « SET »/« RESET » d'un élément mémoire qui peuvent être réalisés avec succès. Une bonne endurance, c'est-à-dire un grand nombre de cycles, est une propriété souhaitée pour une mémoire car cela permet de modifier à de nombreuses reprises l'information qui est stockée dans la mémoire. Chen et al., dans leur article « Balancing SET/RESET Pulse for > 1010 Endurance in HfO2 1T1R Bipolar RRAM » (IEEE Transactions On Electron Devices, pp. 3243-3249, Vol. 59, No. 12, December 2012) étudient l'impact des conditions de « SET » et de « RESET » sur l'endurance d'une mémoire OxRRAM. Deux mécanismes différents de rupture d'endurance sont ainsi mis en évidence :

- un premier mécanisme de rupture d'endurance est lié à des conditions de programmation trop faibles, c'est-à-dire à un courant limité ICSET lors des opérations de « SET » et à des tensions de programmation trop faibles : dans ce premier cas, la cellule mémoire se bloque dans un état de haute résistance HRS, typiquement proche de l'état PRS ;
- un deuxième mécanisme de rupture d'endurance est lié à des conditions de programmations trop fortes, c'est-à-dire à un courant limité ICSET lors des opérations de « SET » et à des tensions de programmation trop fortes : dans ce deuxième cas, la cellule mémoire se bloque dans un état de faible résistance LRS.

L'article recommande de rechercher des conditions de « SET » équilibrées, et en particulier un courant limité ICSET approprié, afin d'améliorer l'endurance d'une cellule mémoire.

Une autre voie de développement concerne la diminution de l'énergie requise pour réaliser les opérations de « SET » et de « RESET » afin de réduire la consommation d'énergie de la mémoire. L'énergie nécessaire aux opérations de « SET » et de « RESET » d'un élément mémoire est notamment déterminée par les conditions de programmation en courant ICSET et en tension VRESET. On souhaite notamment pouvoir utiliser un courant limité ICSET lors des opérations de « SET » le plus faible possible, afin de contribuer à diminuer la consommation d'énergie de l'élément mémoire, tout en ayant la meilleure endurance possible, c'est-à-dire typiquement une endurance supérieure à $10^6$ cycles.

**RESUME DE L'INVENTION**

L'invention offre une solution aux problèmes évoqués précédemment, en proposant un procédé de programmation d'une mémoire vive résistive permettant de minimiser la consommation d'énergie de la mémoire vive résistive tout en ayant une grande endurance, typiquement supérieure à $10^6$ cycles, pour la mémoire vive résistive. Autrement dit, l'invention offre une solution au problème de la réduction de l'endurance d'une mémoire vive résistive lors de l'utilisation de faibles conditions de programmation, que l'on ne souhaite pas augmenter afin de ne pas augmenter la consommation d'énergie de la mémoire vive résistive.

Un aspect de l'invention concerne ainsi un procédé de programmation d'une mémoire vive résistive passant d'un état isolant à un état conducteur, ladite mémoire comprenant une première électrode et une seconde électrode séparées par une couche en matériau électriquement isolant, et passant pour la première fois de l'état isolant à l'état conducteur par application d'une tension seuil VFORMING entre les première et seconde électrodes, un premier courant limité ICFORMING circulant dans ladite mémoire après le passage de l'état isolant à l'état conducteur, le premier courant limité ICFORMING étant limité par des moyens de limitation de courant, le procédé de programmation comportant une étape dite « étape de SET » durant laquelle une tension VSET est appliquée entre les première et seconde électrodes pour le passage de la mémoire vive résistive d'un état conducteur hautement résistif vers un état conducteur faiblement résistif, un deuxième courant limité ICSET circulant dans la mémoire vive résistive après le passage de l'état conducteur hautement résistif à l'état conducteur faiblement résistif, le deuxième courant limité ICSET étant limité par lesdits moyens de limitation de courant, le deuxième courant limité ICSET étant choisi strictement inférieur au premier courant limité ICFORMING.

Grâce à l'invention, on utilise avantageusement lors de la programmation d'une mémoire vive résistive un deuxième courant limité ICSET strictement inférieur au premier courant limité ICFORMING afin d'améliorer l'endurance de la mémoire vive résistive tout en minimisant sa consommation d'énergie. Le déposant a en effet observé de façon surprenante que l'utilisation d'un deuxième courant limité ICSET strictement inférieur au premier courant limité ICFORMING permet d'améliorer l'endurance de la mémoire vive résistive tout en minimisant sa consommation d'énergie.

Une explication de ce comportement pourrait être qu'un premier filament conducteur se forme entre les première et seconde électrodes de la mémoire vive résistive lors d'une étape de FORMING, et que les caractéristiques de ce premier filament conducteur dépendent du premier courant limité ICFORMING. Le premier filament conducteur est ensuite partiellement supprimé lors d'une étape de RESET ; une partie du premier filament conducteur subsiste à l'issue de l'étape de RESET. Lors de l'étape de SET, on estime qu'un deuxième filament conducteur se forme entre la première électrode et la partie résiduelle du premier filament conducteur. Les caractéristiques du deuxième filament conducteur dépendent du deuxième courant limité ICSET. Ainsi, le deuxième courant limité ICSET étant strictement inférieur au premier courant limité ICFORMING, les premier et deuxième filaments conducteurs ne présentent pas les mêmes caractéristiques. L'état conducteur faiblement résistif après l'étape de FORMING est moins résistif que l'état conducteur faiblement résistif après l'étape de SET, avec ICFORMING > ICSET. On estime que la partie résiduelle du premier filament conducteur se comporte comme un réservoir lors de la formation du deuxième filament conducteur durant chaque étape de SET, ce qui permet d'augmenter le nombre de cycles SET/RESET qu'il est possible de réaliser avec la mémoire vive résistive.

Outre les caractéristiques qui viennent d'être évoquées dans le paragraphe précédent, le procédé de programmation d'une mémoire vive résistive selon un aspect de l'invention peut présenter une ou plusieurs caractéristiques complémentaires parmi les suivantes, considérées individuellement ou selon toutes les combinaisons techniquement possibles :

- Le procédé de programmation selon un aspect de l'invention comporte, préalablement à l'étape de SET, les étapes suivantes :

    ◦ une étape dite « étape de FORMING » durant laquelle la tension seuil VFORMING est appliquée entre les première et seconde électrodes pour le passage de la mémoire vive résistive de l'état isolant initial vers l'état conducteur faiblement résistif, le premier courant limité ICFORMING circulant dans la mémoire vive résistive après le passage de l'état isolant initial à l'état conducteur faiblement résistif ;

    ◦ une étape dite « étape de RESET » durant laquelle une tension VRESET est appliquée entre les première et seconde électrodes pour le passage de la mémoire vive résistive de l'état conducteur faiblement résistif vers l'état conducteur hautement résistif.

- Le premier courant limité ICFORMING et le deuxième courant limité ICSET sont tels que :

$$1{,}5 \leq \frac{ICFORMING}{ICSET}$$

- Le premier courant limité ICFORMING et le deuxième courant limité ICSET sont tels que :

$$\frac{ICFORMING}{ICSET} \leq 5$$

- Selon un mode de réalisation, la mémoire vive résistive à programmer par le procédé de programmation selon un aspect de l'invention est une mémoire de type OxRRAM.

- Selon un autre mode de réalisation, la mémoire vive résistive à programmer par le procédé de programmation selon un aspect de l'invention est une mémoire de type CBRAM.

L'invention et ses différentes applications seront mieux comprises à la lecture de la description qui suit et à l'examen des figures qui l'accompagnent.

BREVE DESCRIPTION DES FIGURES

Les figures sont présentées à titre indicatif et nullement limitatif de l'invention.

- La figure 1 illustre schématiquement un dispositif mémoire de type OxRRAM ou CBRAM.
- La figure 2 illustre schématiquement l'évolution de l'énergie de commutation d'un dispositif mémoire en fonction du courant limité ICSET circulant dans le dispositif mémoire lors de chaque opération de « SET », et pour différentes valeurs données de tension VRESET appliquée au dispositif mémoire lors de chaque opération de « RESET ».
- Les figures 3a, 3b, 3c et 3d illustrent schématiquement les étapes d'un procédé de programmation d'une mémoire vive résistive selon un premier mode de réalisation de l'invention.
- La figure 4 est un diagramme des étapes du procédé de programmation d'une mémoire vive résistive selon le premier mode de réalisation de l'invention.

- Les figures 5a, 5b et 5c illustrent schématiquement l'évolution de l'endurance d'un dispositif mémoire en fonction du rapport entre un premier courant limité ICFORMING circulant dans le dispositif mémoire lors d'une étape dite « étape de FORMING » du procédé de programmation selon l'invention et un deuxième courant limité ICSET circulant dans le dispositif mémoire lors d'une étape dite « étape de SET » du procédé de programmation selon l'invention.
- La figure 6 illustre schématiquement l'évolution du rapport entre le premier courant limité ICFORMING et le deuxième courant limité ICSET en fonction de la tension VRESET appliquée au dispositif mémoire lors de chaque opération de « RESET », pour une valeur d'endurance donnée.

## DESCRIPTION DETAILLEE D'AU MOINS UN MODE DE REALISATION DE L'INVENTION

Sauf précision contraire, un même élément apparaissant sur des figures différentes présente une référence unique.

Dans la présente description, les termes « courant limité », « limitation de courant » ou « courant d'ajustement » (« compliance » en anglais) sont employés indifféremment. On emploie indifféremment les termes « état initial PRS », « état isolant PRS », « état initial isolant PRS » ou « état PRS » (de l'anglais « Pristine Résistance State »). On emploie indifféremment les termes « état conducteur faiblement résistif », « état faiblement résistif LRS » et « état LRS » (de l'anglais « Low Resistive State »). On emploie indifféremment les termes « état conducteur de haute résistance HRS », « état de haute résistance HRS » et « état HRS » (de l'anglais « High Resistive State »).

La figure 1 a été décrite précédemment.

La figure 2 illustre schématiquement l'évolution de l'énergie de commutation d'une mémoire vive résistive en fonction du courant limité ICSET circulant dans la mémoire vive résistive lors de chaque opération de « SET », et pour différentes valeurs données de tension VRESET appliquée à la mémoire vive résistive lors de chaque opération de « RESET ».

La figure 2 montre ainsi :

- une première courbe C1 de l'énergie de commutation de la mémoire vive résistive en fonction du courant limité ICSET circulant dans la mémoire vive résistive lors de chaque opération de « SET », pour une valeur de tension VRESET appliquée à la mémoire vive résistive lors de chaque opération de « RESET » de 1,7 V ;
- une deuxième courbe C2 de l'énergie de commutation de la mémoire vive résistive en fonction du courant limité ICSET circulant dans la mémoire vive résistive lors de chaque opération de « SET », pour une valeur de tension VRESET appliquée à la mémoire vive résistive lors de chaque opération de « RESET » de 1,5 V ;
- une troisième courbe C3 de l'énergie de commutation de la mémoire vive résistive en fonction du courant limité ICSET circulant dans la mémoire vive résistive lors de chaque opération de « SET », pour une valeur de tension VRESET appliquée à la mémoire vive résistive lors de chaque opération de « RESET » de 1,3 V.

Les première, deuxième et troisième courbes C1, C2 et C3 montrent que plus la tension VRESET de chaque opération de « RESET » est grande, plus l'énergie de commutation de la mémoire vive résistive, pour une valeur donnée de courant limité ICSET de chaque opération de « SET », est importante.

Les première, deuxième et troisième courbes C1, C2 et C3 montrent également que plus le courant ICSET de chaque opération de « SET » est grand, plus l'énergie de commutation de la mémoire vive résistive, pour une valeur donnée de tension VRESET de chaque opération de « RESET », est importante.

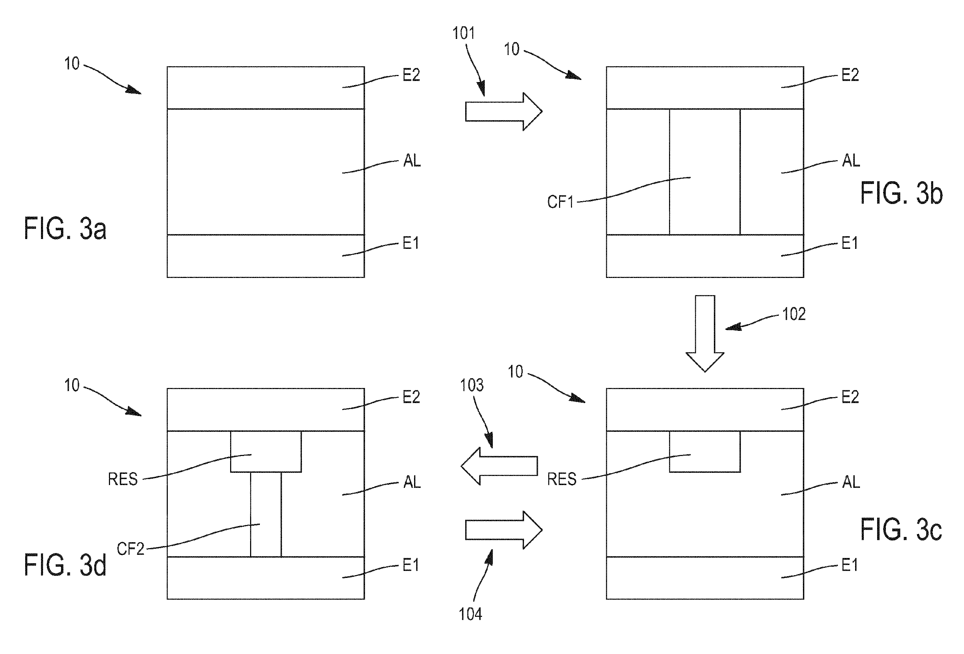

Les figures 3a, 3b, 3c et 3d illustrent schématiquement les étapes du procédé 100 de programmation d'une mémoire vive résistive 10 selon un premier mode de réalisation de l'invention. Les figures 3a, 3b, 3c et 3d sont décrites conjointement.

La figure 3a montre une mémoire vive résistive 10 comportant une zone active de mémorisation AL disposée entre une première électrode conductrice E1, ou électrode inférieure, et une seconde électrode conductrice E2, ou électrode supérieure. La mémoire vive résistive 10 de la figure 3a se trouve dans un état initial isolant PRS.

Le procédé 100 de programmation selon un aspect de l'invention est décrit plus en détails dans ce qui suit dans le cas d'une mémoire vive résistive 10 de type OxRRAM, ou « Oxyde RRAM », comportant une zone active de mémorisation AL basée sur un matériau actif à base d'oxyde, tel qu'un oxyde binaire d'un métal de transition, entouré de deux électrodes métalliques. Il s'agit donc d'une structure Métal-Oxyde-Métal basée sur le changement de résistance de la couche d'oxyde qui passe d'un état hautement résistif HRS à un état faiblement résistif LRS lorsqu'on applique une tension d'écriture VSET suffisante aux bornes des électrodes, et qui passe d'un état faiblement résistif LRS à un état hautement résistif HRS lorsqu'on applique une tension d'effacement VRESET suffisante aux bornes des électrodes. Il existe un nombre important d'oxydes binaires présentant la capacité de changer de résistance de manière réversible. Ces mémoires peuvent être bipolaires, c'est-à-dire avec des tensions de SET et de RESET de signes opposés, ou unipolaires, c'est-à-dire avec des tensions de SET et de RESET de même signe. Elles peuvent également fonctionner dans certains cas dans les deux modes, bipolaire et unipolaire. La mémoire vive résistive 10 est par exemple une mémoire OxRRAM de type TiN/Ti/HfO2/TiN, ayant donc une première électrode E1 inférieure en TiN, une zone active AL en HfO2 et une deuxième électrode E2 supérieure formée d'un bicouche TiN/Ti. Alternativement, la mémoire vive résistive 10 peut être une mémoire OxRRAM de type TiN/Hf/HfO2/TiN, ou une mémoire OxRRAM de type Ti/HfO2/TiN, ou une mémoire OxRRAM de type Pt/TiO2/Pt, ou une mémoire OxRRAM de type Ta/TaOx/TiN. Les exemples de mémoire OxRRAM ci-dessus sont donnés à titre purement illustratif et non limitatif.

Le procédé 100 de programmation selon un aspect de l'invention s'applique également à aux mémoires vives résistives de type CBRAM, présentant un électrolyte solide disposé entre une électrode formant une cathode inerte et une électrode comportant une portion de métal ionisable - contrairement aux mémoires vives résistives de type OxRRAM, dont les électrodes métalliques sont choisies pour être peu facilement ionisables. Un exemple de mémoire CBRAM est par exemple formé par un empilement comportant un électrolyte solide, par exemple à base de chalcogénure dopé (ex. GeS) ou d'oxyde (ex. $Al_2O_3$), disposé entre une électrode inférieure, par exemple en Pt, formant une cathode inerte, et une électrode supérieure comportant une portion de métal ionisable, par exemple du cuivre, formant une anode.

La figure 3b montre la mémoire vive résistive 10 à l'issue d'une première étape 101, dite « de FORMING ». Durant l'étape 101 de FORMING, une tension seuil VFORMING est appliquée entre la première électrode E1 et la seconde électrode E2 pour le passage de la mémoire vive résistive 10 de l'état isolant initial PRS vers un état conducteur faiblement résistif LRS. Sous l'effet de la tension seuil VFORMING, un premier filament conducteur CF1 se forme dans la zone active de mémorisation AL, entre la première électrode E1 et la seconde électrode E2. Durant l'étape 101 de FORMING et après le passage de la mémoire résistive 10 de l'état isolant initial PRS vers l'état conducteur faiblement résistif LRS, un premier courant limité ICFORMING circule dans la mémoire vive résistive 10. Le premier courant limité ICFORMING est typiquement limité par un moyen de limitation, tel qu'un transistor en série avec la mémoire vive résistive 10.

La figure 3c montre la mémoire vive résistive 10 à l'issue d'une deuxième étape 102, dite « de premier RESET ». Durant l'étape 102 de premier RESET, une tension VRESET est appliquée entre la première électrode E1 et la seconde électrode E2 de la mémoire vive résistive 10, pour le passage de la mémoire vive résistive 10 de l'état conducteur faiblement résistif LRS vers un état conducteur hautement résistif HRS. Sous l'effet de l'application de la tension VRESET, le premier filament conducteur CF1 est partiellement supprimé. A l'issue de l'étape 102 de premier RESET, il subsiste une partie résiduelle RES du premier filament conducteur CF1 dans la zone active de mémorisation AL. La partie résiduelle RES se trouve typiquement au contact de la seconde électrode E2.

La figure 3d montre la mémoire vive résistive 10 à l'issue d'une troisième étape 103, dite « de SET ». Durant l'étape 103 de SET, une tension VSET est appliquée entre la première électrode E1 et la seconde électrode E2 de la mémoire vive résistive 10, pour le passage de la mémoire vive résistive 10 de l'état conducteur hautement résistif HRS vers l'état conducteur faiblement résistif LRS. Sous l'effet de la tension VSET, un deuxième filament conducteur CF2 se forme dans la zone active de mémorisation AL, entre la première électrode E1 et la partie résiduelle RES du premier filament conducteur CF1. Durant l'étape 103 de SET et après le passage de l'état conducteur hautement résistif HRS à l'état conducteur faiblement résistif LRS, un deuxième courant limité ICSET circule dans la mémoire vive résistive 10. Le deuxième courant limité ICSET est typiquement limité par un moyen de limitation, tel qu'un transistor en série avec la mémoire vive résistive 10. Avantageusement, un même moyen de limitation est utilisé pour limiter le premier courant limité ICFORMING et pour limiter le deuxième courant limité ICSET, tel qu'un transistor dont on fait varier le niveau de limitation à l'aide de la tension de grille.

Suivant le procédé 100 de programmation selon le premier mode de réalisation de l'invention, le premier courant limité ICFORMING et le deuxième courant limité ICSET sont choisis tels que :

$$ICFORMING > ICSET$$

De manière préférentielle, le premier courant limité ICFORMING et le deuxième courant limité ICSET sont également choisis tels que :

$$1,5 \le \frac{ICFORMING}{ICSET}$$

Enfin, de manière préférentielle, le premier courant limité ICFORMING et le deuxième courant limité ICSET sont également choisis tels que :

$$\frac{ICFORMING}{ICSET} \le 5$$

Ainsi, le premier courant limité ICFORMING et le deuxième courant limité ICSET sont préférentiellement choisis tels que :

$$1,5 \le \frac{ICFORMING}{ICSET} \le 5$$

Le deuxième courant limité ICSET contribue à déterminer la valeur de la résistance de la mémoire vive résistive dans son état LRS, ainsi que la consommation d'énergie de programmation. On choisit donc typiquement d'abord la valeur du deuxième courant limité ICSET en fonction de la valeur souhaitée pour la résistance de la mémoire vive résistive dans son état LRS, et des performances visées en matière de consommation d'énergie de programmation. Puis on choisit la valeur du premier courant limité ICFORMING en fonction de la valeur du deuxième courant limité ICSET précédemment déterminée. Le deuxième courant limité ICSET est typiquement compris entre 10 μA et 1 mA. Le premier courant limité ICFORMING est typiquement compris entre 15 μA et 1,5 mA.

La figure 3c, précédemment décrite, montre également la mémoire vive résistive 10 à l'issue d'une quatrième étape 104, dite «de RESET». Durant l'étape 104 de RESET, de manière analogue à l'étape 102 de premier RESET précédemment décrite, la tension VRESET est appliquée entre la première électrode E1 et la seconde électrode E2 de la mémoire vive résistive 10, pour le passage de la mémoire vive résistive 10 de l'état conducteur faiblement résistif LRS vers un état conducteur hautement résistif HRS. La tension VRESET appliquée lors de l'étape 104 de RESET est préférentiellement identique à la tension VRESET appliquée lors de l'étape 102 de premier RESET. Sous l'effet de l'application de la tension VRESET, le deuxième filament conducteur CF2 est au moins partiellement supprimé. A l'issue de l'étape 104 de RESET, il subsiste la partie résiduelle RES du premier filament conducteur CF1 dans la zone active de mémorisation AL.

La troisième étape de SET et la quatrième étape de RESET peuvent ensuite être répétées autant de fois que souhaité, dans la limite de l'endurance de la mémoire vive résistive 10. L'endurance de la mémoire vive résistive 10 correspond en effet au nombre de cycles SET/RESET qu'il est possible de réaliser avant que la mémoire vive résistive ne se bloque dans l'un ou l'autre état.

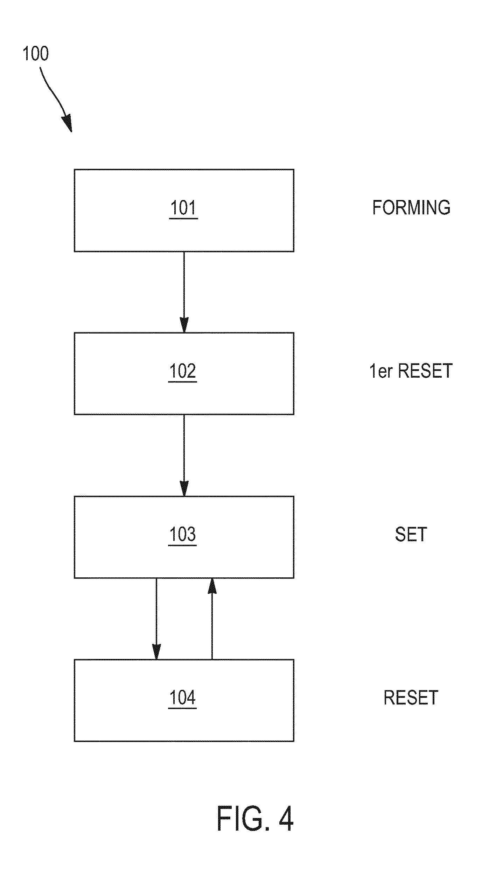

La figure 4 est un diagramme des étapes du procédé 100 de programmation de la mémoire vive résistive 10 précédemment décrite, selon le premier mode de réalisation de l'invention. Le procédé 100 comporte ainsi successivement :

- la première étape 101 de FORMING ;
- la deuxième étape 102 de premier RESET ;
- la troisième étape 103 de SET ;
- la quatrième étape 104 de RESET.

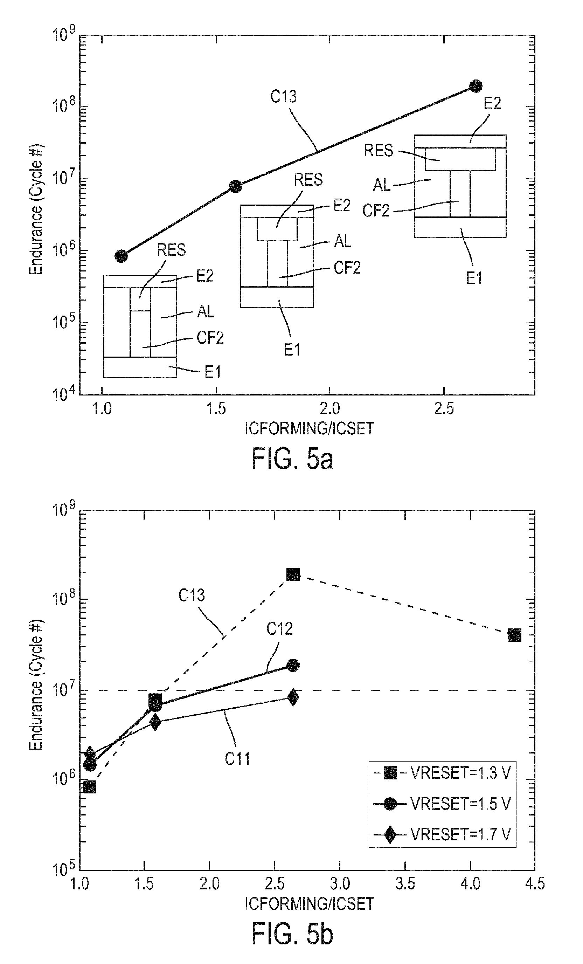

La figure 5a montre une courbe expérimentale C13 de l'évolution de l'endurance de la mémoire vive résistive 10 en fonction du rapport ICFORMING/ICSET entre le premier courant limité ICFORMING et le deuxième courant limité ICSET, pour une tension VRESET de 1,3 V et pour un deuxième courant limité ICSET de 230 μA. La figure 5a montre que les performances en endurance de la cellule mémoire résistive 10 augmentent lorsque le premier courant limité ICFORMING est strictement supérieur au deuxième courant limité ICSET. Une explication de ce comportement pourrait être que plus le rapport ICFORMING/ICSET augmente, plus le réservoir formé par la partie résiduelle RES du premier filament conducteur CF1 est grand, ainsi que schématiquement représenté sur la figure 5a.

En complément de la figure 5a, la figure 5b illustre schématiquement l'évolution de l'endurance de la mémoire vive résistive 10 précédemment décrite, en fonction du rapport ICFORMING/ICSET entre le premier courant limité ICFORMING et le deuxième courant limité ICSET, pour différentes valeurs de tension VRESET et pour un deuxième courant limité ICSET de 230 μA.

La figure 5b montre ainsi :

- une courbe expérimentale C11 de l'évolution de l'endurance de la mémoire vive résistive 10 en fonction du rapport ICFORMING/ICSET entre le premier courant limité ICFORMING et le deuxième courant limité ICSET, pour une tension VRESET de 1,7 V ;
- une courbe expérimentale C12 de l'évolution de l'endurance de la mémoire vive résistive 10 en fonction du rapport ICFORMING/ICSET entre le premier courant limité ICFORMING et le deuxième courant limité ICSET, pour une tension VRESET de 1,5 V ;
- la courbe expérimentale C13 de l'évolution de l'endurance de la mémoire vive résistive 10 en fonction du rapport ICFORMING/ICSET entre le premier courant limité ICFORMING et le deuxième courant limité ICSET, pour une tension VRESET de 1,3 V.

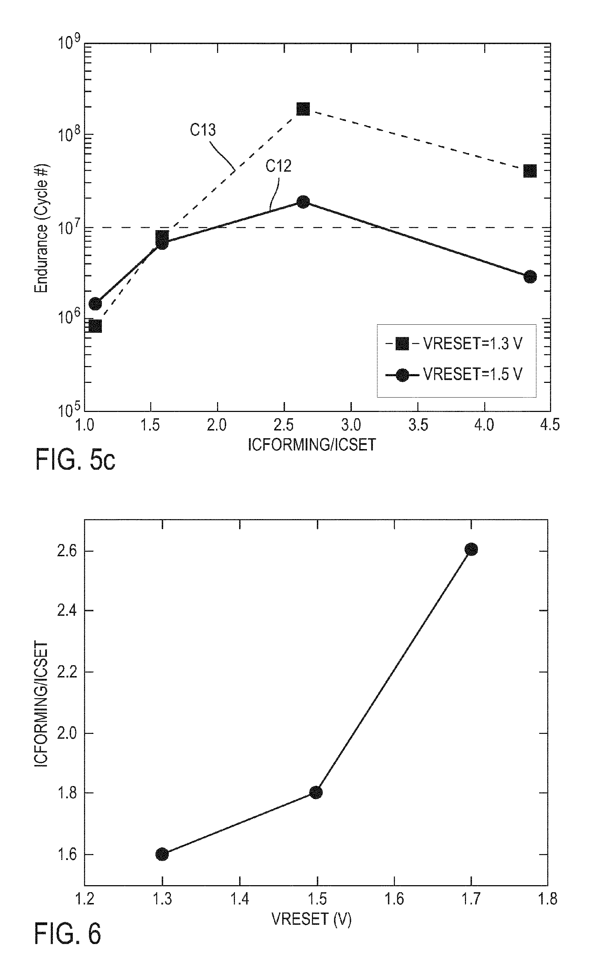

La figure 5b montre que les performances en endurance de la cellule mémoire résistive 10 augmentent lorsque le premier courant limité ICFORMING est strictement supérieur au deuxième courant limité ICSET. La figure 5 montre également que le rapport ICFORMING/ICSET entre le premier courant limité ICFORMING et le deuxième courant limité ICSET est préférentiellement inférieur ou égal à cinq. En effet, un rapport ICFORMING/ICSET supérieur à cinq implique une valeur élevée pour le premier courant limité ICFORMING, susceptible de dégrader les propriétés de la mémoire vive résistive 10.

En complément de la figure 5b, la figure 5c illustre schématiquement l'évolution de l'endurance de la mémoire vive résistive 10 précédemment décrite, en fonction du rapport ICFORMING/ICSET entre le premier courant limité ICFORMING et le deuxième courant limité ICSET, pour différentes valeurs de tension VRESET et pour un deuxième courant limité ICSET de 230 μA. La figure 5c montre ainsi :

- la courbe expérimentale C12 de l'évolution de l'endurance de la mémoire vive résistive 10 en fonction du rapport ICFORMING/ICSET entre le premier courant limité ICFORMING et le deuxième courant limité ICSET, pour une tension VRESET de 1,5 V ;
- la courbe expérimentale C13 de l'évolution de l'endurance de la mémoire vive résistive 10 en fonction du rapport ICFORMING/ICSET entre le premier courant limité ICFORMING et le deuxième courant limité ICSET, pour une tension VRESET de 1,3 V.

La figure 6 est une courbe expérimentale de l'évolution du rapport entre le premier courant limité ICFORMING et le deuxième courant limité ICSET en fonction de la tension VRESET appliquée au dispositif mémoire lors de chaque opération de « RESET », pour une valeur d'endurance de la mémoire vive résistive 10 de $10^7$ cycles.

Augmenter la valeur de tension VRESET permet avantageusement d'augmenter la fenêtre mémoire de la mémoire vive résistive 10, c'est-à-dire le rapport HRS/LRS entre la résistance de la mémoire vive résistive 10 dans son état hautement résistif HRS et la résistance de la mémoire vive résistive 10 dans son état faiblement résistif LRS.

Diminuer au contraire la valeur de tension VRESET permet avantageusement de diminuer la consommation énergétique de la mémoire vive résistive 10. En effet, pour une endurance cible donnée, par exemple de $10^7$ cycles dans l'exemple particulier de la figure 6, lorsque la valeur de tension VRESET augmente, le rapport ICFORMING/ICSET requis pour parvenir à l'endurance cible augmente. Donc, lorsque la valeur de tension VRESET augmente, la consommation énergétique de la mémoire vive résistive 10 augmente, à endurance constante. La figure 6 montre également que, pour des valeurs de tension VRESET inférieures ou égales à 1,7 V, le rapport ICFORMING/ICSET demeure inférieur ou égal à 2,6. La figure 6 montre donc que le procédé 100 de programmation de la mémoire vive résistive 10 selon le premier mode de réalisation de l'invention demeure fonctionnel lorsque la valeur de la tension VRESET augmente.

**Revendications**

1. Procédé (100) de programmation d'une mémoire vive résistive (10) passant d'un état isolant à un état conducteur, ladite mémoire comprenant une première électrode (E1) et une seconde électrode (E2) séparées par une couche (AL) en matériau électriquement isolant, et passant pour la première fois de l'état isolant à l'état conducteur par application d'une tension seuil VFORMING entre les première et seconde électrodes (E1, E2), un premier courant limité ICFORMING circulant dans ladite mémoire après le passage de l'état isolant à l'état conducteur, le premier courant limité ICFORMING étant limité par des moyens de limitation de courant, le procédé (100) de programmation comportant une étape (103) dite « étape de SET » durant laquelle une tension VSET est appliquée entre les première et seconde électrodes (E1, E2) pour le passage de la mémoire vive résistive (10) d'un état conducteur hautement résistif vers un état conducteur faiblement résistif, un deuxième courant limité ICSET circulant dans la mémoire vive résistive (10) après le passage de l'état conducteur hautement résistif à l'état conducteur faiblement résistif, le deuxième courant limité ICSET étant limité par lesdits moyens de limitation de courant, le deuxième courant limité ICSET étant choisi strictement inférieur au premier courant limité ICFORMING.

2. Procédé (100) de programmation selon la revendication précédente comportant, préalablement à l'étape (103) de SET, l'étape suivante :

   - une étape (102, 104) dite «étape de RESET » durant laquelle une tension VRESET est appliquée entre les première et seconde électrodes (E1, E2) pour le passage de la mémoire vive résistive (10) de l'état conducteur faiblement résistif vers l'état conducteur hautement résistif.

3. Procédé (100) de programmation selon la revendication précédente comportant, préalablement à l'étape (102) de RESET, l'étape suivante :

   - une étape (101) dite « étape de FORMING » durant laquelle la tension seuil VFORMING est appliquée entre les première et seconde électrodes (E1, E2) pour le passage de la mémoire vive résistive (10) de l'état isolant initial vers l'état conducteur faiblement résistif, le premier courant limité ICFORMING circulant dans la mémoire vive résistive (10) après le passage de l'état isolant initial à l'état conducteur faiblement résistif.

4. Procédé (100) de programmation selon l'une quelconque des revendications précédentes **caractérisé en ce que** le premier courant limité ICFORMING et le deuxième courant limité ICSET sont tels que :

$$1,5 \leq \frac{ICFORMING}{ICSET}$$

5. Procédé (100) de programmation selon l'une quelconque des revendications précédentes **caractérisé en ce que** le premier courant limité ICFORMING et le deuxième courant limité ICSET sont tels que :

$$\frac{ICFORMING}{ICSET} \leq 5$$

6. Utilisation du procédé (100) de programmation selon l'une quelconque des revendications précédentes pour programmer une mémoire de type OxRRAM.

7. Utilisation du procédé (100) de programmation selon l'une quelconque des revendications 1 à 5 pour programmer une mémoire de type CBRAM.

FIG. 1

FIG. 2

EP 3 029 680 A1

FIG. 3a

10 → 

E2

AL

E1

101 →

10 →

E2

CF1

AL

E1

FIG. 3b

102 →

FIG. 3d

10 →

E2

RES

AL

CF2

E1

103 →

RES

104 →

10 →

E2

RES

AL

E1

FIG. 3c

100

| | |
|---|---|
| **101** | FORMING |

| | |
|---|---|
| **102** | 1er RESET |

| | |
|---|---|
| **103** | SET |

| | |
|---|---|
| **104** | RESET |

FIG. 4

FIG. 5a

FIG. 5b

FIG. 5c

FIG. 6

Europäisches
Patentamt

European
Patent Office

Office européen
des brevets

## RAPPORT DE RECHERCHE EUROPEENNE

Numéro de la demande

EP 15 19 6806

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2010/271860 A1 (MURAOKA SHUNSAKU [JP] ET AL) 28 octobre 2010 (2010-10-28) * revendications 1,5,11-13; figures 1,2,3,5,9 * | 1-7 | INV. G11C7/20 G11C13/00 G11C29/02 |
| X | US 2011/002158 A1 (MURAOKA SHUNSAKU [JP] ET AL) 6 janvier 2011 (2011-01-06) * alinéa [0123]; revendications 1,7,15-17; figures 1-4,9,10 * | 1-7 | |
| X | US 2014/264224 A1 (ZHANG XUENA [US] ET AL) 18 septembre 2014 (2014-09-18) * figure 2 * | 1 | |
| A,D | YANG YIN CHEN ET AL: "Balancing SET/RESET Pulse for >10^10 Endurance in HfO2/Hf 1T1R Bipolar RRAM", IEEE TRANSACTIONS ON ELECTRON DEVICES, IEEE SERVICE CENTER, PISACATAWAY, NJ, US, vol. 59, no. 12, 1 décembre 2012 (2012-12-01), pages 3243-3249, XP011472276, ISSN: 0018-9383, DOI: 10.1109/TED.2012.2218607 * page 2, colonne de gauche; figures 4-8 * | 1-7 | DOMAINES TECHNIQUES RECHERCHES (IPC) G11C |
| A | US 2014/254240 A1 (PERNIOLA LUCA [FR]) 11 septembre 2014 (2014-09-11) * page 6, alinéa 99 * | 1-7 | |

Le présent rapport a été établi pour toutes les revendications

| Lieu de la recherche | Date d'achèvement de la recherche | Examinateur |
|---|---|---|
| La Haye | 21 mars 2016 | Kontogiannis, K |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 15 19 6806

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-03-2016

| Document brevet cité au rapport de recherche | | Date de publication | Membre(s) de la famille de brevet(s) | | Date de publication |
|---|---|---|---|---|---|
| US 2010271860 | A1 | 28-10-2010 | CN | 101878507 A | 03-11-2010 |
| | | | JP | 4485605 B2 | 23-06-2010 |
| | | | US | 2010271860 A1 | 28-10-2010 |
| | | | WO | 2010038442 A1 | 08-04-2010 |
| US 2011002158 | A1 | 06-01-2011 | CN | 101952893 A | 19-01-2011 |
| | | | JP | 4607252 B2 | 05-01-2011 |
| | | | US | 2011002158 A1 | 06-01-2011 |
| | | | WO | 2009107370 A1 | 03-09-2009 |
| US 2014264224 | A1 | 18-09-2014 | US | 9029187 B1 | 12-05-2015 |
| | | | US | 2014264224 A1 | 18-09-2014 |
| | | | US | 2014264239 A1 | 18-09-2014 |
| | | | US | 2014264241 A1 | 18-09-2014 |
| | | | US | 2014269004 A1 | 18-09-2014 |
| | | | US | 2014273300 A1 | 18-09-2014 |
| US 2014254240 | A1 | 11-09-2014 | EP | 2765575 A1 | 13-08-2014 |
| | | | FR | 3002072 A1 | 15-08-2014 |
| | | | US | 2014254240 A1 | 11-09-2014 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **CHEN et al.** Balancing SET/RESET Pulse for > 1010 Endurance in HfO2 1T1R Bipolar RRAM. *IEEE Transactions On Electron Devices,* Décembre 2012, vol. 59 (12), 3243-3249